(19) Europäisches Patentamt / European Patent Office / Office européen des brevets

(11) **EP 4 387 408 A1**

(12) **EUROPEAN PATENT APPLICATION**

(43) Date of publication:
**19.06.2024 Bulletin 2024/25**

(21) Application number: **22213124.5**

(22) Date of filing: **13.12.2022**

(51) International Patent Classification (IPC):
***H05K 9/00*** (2006.01)

(52) Cooperative Patent Classification (CPC):
**H05K 9/0079**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Hitachi Energy Ltd**
**8050 Zürich (CH)**

(72) Inventors:
• **RUSSBERG, Gunnar**
  **724 62 Västerås (SE)**
• **SALINAS, Ener**
  **722 10 Västerås (SE)**
• **MUKHERJEE, Pritam**
  **722 27 Västerås (SE)**
• **LUVISOTTO, Michele**
  **722 19 Västerås (SE)**
• **GIRLANDA, Orlando**
  **723 56 Västerås (SE)**
• **PRADHAN, Manoj Kumar**
  **724 76 Västerås (SE)**

(74) Representative: **Valea AB**
**Box 7086**
**103 87 Stockholm (SE)**

(54) **AN ELECTROSTATIC SHIELDING ELEMENT, AN ELECTROSTATIC SHIELDING ARRANGEMENT AND A TRANSFORMER ARRANGEMENT COMPRISING THE ELECTROSTATIC SHIELDING ARRANGEMENT**

(57)     The disclosure relates to an electrostatic shielding element (1) arranged on a first axis (z) and comprising an electrostatically shielded volume (14) at least partially closed by an electrically conductive coating (12), wherein a thickness (d) and an electrical conductivity ($\sigma$) of the coating (12) are selected to enable a magnetic field of a predetermined frequency (f) to penetrate the coating, into the volume (14). The disclosure also relates to an electrostatic shielding arrangement (2) and to a transformer arrangement (3).

Fig. 6

# Description

TECHNICAL FIELD

The present disclosure relates to an electrostatic shielding element and an electrostatic shielding arrangement comprising at least two electrostatic shielding elements. More in particular, the present disclosure relates to an electrostatic shielding element comprising an electrostatically shielded volume which is penetrable by magnetic field up to a predetermined frequency.

BACKGROUND

It is difficult to place electronic devices in environments exposed to high voltage due to interaction of the device with a background electric field leading complex considerations regarding insulation of both the electronic device and surrounding devices in the high voltage environment. The complexity is heightened if the device also requires magnetic coupling with equipment or instruments external to the electric field.

Electronic devices in high voltage environments require electrostatic shielding since electrically conducting objects in high electric field environments cause field intensification, which leads to increased probability of partial discharge and accelerated aging of any adjacent dielectric components and/or materials. Electrostatic shielding terminates the electric field lines at a boundary of the shielded region and may also prevent a magnetic field from penetrating the shield. It is therefore difficult to provide magnetic interaction, such as power transfer and/or signalling with a shielded device from outside the shielded region.

An electrostatic shield needs to fulfil at least three requirements:

- A conductivity of the shielding material should not be too low in order to provide an equipotential surface.
- The conductivity of the shielding material should not be too high in order to avoid induced eddy currents which repel the incident magnetic flux, and
- A thickness of the shield should be sufficient to achieve mechanical stability but should be less than the skin depth of the magnetic field.

SUMMARY

Therefore, an object of the disclosure is to provide an improved electrostatic shield. In particular, an object of the disclosure is to provide an electrostatic shield allowing power transfer and/or signalling with a shielded electronic device.

According to a first aspect of the present disclosure, the object is at least partly achieved by an electrostatic shielding element according to claim 1.

Hence, there is provided an electrostatic shielding element arranged on a first axis and comprising an electrostatically shielded volume at least partially closed by an electrically conductive coating. A thickness and an electrical conductivity of the coating are selected to enable a magnetic field of a predetermined frequency to penetrate the coating, into the volume.

The electrostatically shielded volume is configured to be protected from an electric field at 50Hz/60Hz working frequencies. To this end, the coating material needs to be sufficiently electrically conductive. The coating material also needs to be continuous to fully close the volume.

By appropriately selecting the conductivity and thickness of the coating, the magnetic field is enabled to penetrate the volume to enable power transfer and signalling to electrical devices comprised in the volume.

The coating is preferably a conductive metallic coating. Eddy currents are induced in the coating when the coating is exposed to an incident magnetic field. The eddy current effect increases with increasing frequency of the magnetic field and prevents the magnetic field from penetrating the shielded volume. The eddy current effect decreases with decreasing conductivity of the coating material.

A thicker coating requires a lower conductivity than a thinner coating to allow penetration of the magnetic field. However, a thicker coating has a better mechanical strength than a thinner coating.

Optionally, the electrostatically shielded volume is fully closed by the electrically conductive coating.

For a single shielding element, the electrostatically shielded volume needs to be fully closed by the electrically conductive coating. The volume may be partially closed, i.e. partly open, if an open area of the volume is covered by an adjacent galvanically connected conductive body, such as another shielding element.

Optionally, the volume extends laterally from the first axis. The volume may be disc-shaped, having a significantly larger lateral extension from the first axis than along the first axis.

Optionally, the volume is circular or elliptical around the first axis. A circular volume has a radius extending orthogonally from the first axis. An elliptical volume extends a first distance along a second (major) axis orthogonal to the first axis, and extends a second distance along a third (minor) axis orthogonal to both the first axis and to the second axis.

Since field intensification arises at sharp corners and edges, a circular or elliptical volume around the first axis is envisaged. Further, a radial outer edge of the volume may have a rounded shape in a plane parallel with the first axis. A radius of curvature of the radial outer edge may preferably be half a volume thickness, as seen along the first axis, at the radial outer edge.

Optionally, for the predetermined frequency, the electrical conductivity and the thickness of the coating are selected so that

$$\sigma d^2 < \frac{c}{f}$$

wherein $c \leq 40\,000$ Sm/s, more preferably $c \leq 5\,000$ Sm/s, and most preferably $c \leq 1\,000$ Sm/s.

The frequency of the magnetic field for power transfer and signalling applications is conventionally between 20kHz and 20MHz. Designing electric devices and electronic components for a predetermined frequency in the range thereby limits the range of selectable coating conductivities/materials and coating thicknesses. The constant c may be selected to ensure that at least a part of a signal power of the magnetic field may penetrate the coating. At c = 40 000 Sm/s, around 10% of the signal power penetrates the coating. At c = 5 000 Sm/s, around 50% of the signal power penetrates the coating. At c = 1 000 Sm/s, around 90% of the signal power penetrates the coating.

Optionally, the thickness of the electrically conductive layer is less than, or equal to 1 mm.

Optionally, the electrical conductivity of the electrically conductive layer is in the range of 1 S/m - $10^8$ S/m, preferably in the range of $10^3$ S/m - $10^8$ S/m, and most preferably $10^5$ S/m - $10^8$ S/m.

A conductivity of less than $10^8$ S/m covers conductive materials. It is also conceivable to use coatings of semiconductor materials, such as at $10^5$ S/m and materials such as carbon/graphite at around 1 S/m.

Optionally, the electrostatic shielding element comprises at least one electric device enclosed in the volume. The electric device is configured to receive electric power by inductive coupling, and/or to be communicatively coupled to a magnetic field of the predetermined frequency.

The electric device may thus be enclosed and electrostatically shielded inside the coated volume. Electric power may be inductively received and transferred to another electric device or component. In addition, the electric device may be communicatively coupled to the magnetic field to receive and/or to send signals via the magnetic field to/from receivers/transmitters outside the electrostatically shielded volume. The electrostatic shielding element may thereby be located in a high voltage electric field without risking damage to the electric device or to surrounding instruments and/or equipment.

Optionally, the electric device comprises at least one LC circuit.

The LC circuit may comprise a single LC circuit or multiple LC circuits, such as an array of LC circuits.

According to a second aspect of the present disclosure, the object is at least partly achieved by an electrostatic shielding arrangement according to claim 9.

Hence, there is provided an electrostatic shielding arrangement comprising at least two electrostatic shielding elements, according to any one of the embodiments for the first aspect of the disclosure, galvanically connected to each other. The at least two electrostatic shielding elements are arranged along the first axis, spaced from each other, forming an electrostatically shielded space therebetween.

The galvanic connection between the at least two electrostatic shielding elements thus ensures an equipotential surface across a surface of the entire electrostatic shielding arrangement. They are both arranged on the first axis, e.g. in parallel along the first axis. The electrostatically shielded space between the electrostatic shielding elements therefore also extends laterally from the first axis. The space may comprise any components that require shielding from the electric field, but which require contact with the environment outside the electrostatic shielding elements.

Optionally, the at least two electrostatic shielding elements are mechanically and galvanically connected to each other via at least one electrically conductive fixing element.

The galvanic connection may be achieved by an electrically conductive fixing element, such as a screw or bolt, which engages the at least two electrostatic shielding elements. The fixing element may also be electrically conductive by being provided by a conductive coating, such as the same coating as the at least two electrostatic shielding elements.

Optionally, the electrostatic shielding arrangement comprises at least one electronic component arranged in the electrostatically shielded space, and the electric device is electrically connected to the electronic component.

The electronic component may be located in the electrostatically shielded space without risking interference from the electric field. The electric component may be electrically connected to the electric device inside the electrostatic shielding element via an electric conductor passing through the coating of the electrostatic shielding element in an area bordering the electrostatically shielded space.

Optionally, the at least two electrostatic shielding elements are spaced at least a separation distance from each other, and the electronic component is located in the shielded space, at least at the separation distance from a radial periphery of the at least two electrostatic shielding elements.

As a rule of thumb, the electric field is negligible at a distance equalling the separation distance from the radial periphery of the at least two electrostatic shielding elements. Therefore, the component is protected if it is located in the electrostatically shielded space at least the separation distance from the radial periphery of the electrostatic shielding elements.

Optionally, the electronic component is a sensor electrically powered by, and/or communicatively coupled to the electric device.

A sensor located in the electrostatically shielded space is exposed to the environment in which the electrostatic shielding arrangement is positioned. Such a sensor may therefore measure properties such as temperature, pressure, humidity, etc., without being exposed to the electric field and without risking field intensification and/or electric breakdown of the medium in which it is placed, which could lead to damaging arcing. The sensor may be powered by the electric device which is inductively coupled to the magnetic field. Any sensor data may be wirelessly transmitted via the electric device and the magnetic field to a remote control unit. "Remote" is herein to be understood as remote from, or outside, the electric/magnetic field.

Optionally, the shielded space comprises a field grading material or a dielectric material.

The field grading material may be a non-linear resistive field grading material. The primary characteristic of a non-linear resistive field grading material is that the electrical conductivity increases above a threshold electric field amplitude and therefore can be used to reduce a maximum field stress at locations inside the insulation system. A field grading material composite may generally be composed of a base polymer e.g. SiR, ethylene propylene-diene monomer rubber, epoxy resins or thermoplastics and may be filled with a single or plurality of fillers, often conducting or semiconducting to achieve nonlinear behaviour. The non-linear conductivity behaviour of the composite originates from the semiconducting fillers. A filler material may be silicon carbide but alternatives exist.

Any suitable dielectric material may be used, such as pressboard, paper, cellulose or impregnated cellulose, dielectric polymer, etc. A fluid dielectric material may alternatively be used or to complement a solid dielectric material. Fluid dielectric materials may be exemplified by air, oil, etc. The field grading material or dielectric material may partially or fully fill out the shielded space.

According to a third aspect of the present disclosure, the object is at least partly achieved by a transformer arrangement according to claim 15.

Hence, there is provided a transformer arrangement comprising a transformer and the electrostatic shielding arrangement according to any one of the embodiments of the second aspect of the disclosure.

The electrostatic shielding arrangement may be provided in a transformer arrangement. It may protect and drive sensors to monitor the transformer during operation. Due to the shielding properties of the electrostatic shielding element, the transformer does not need to be disconnected for any sensors to perform measurements.

The above aspects, accompanying claims, and/or examples disclosed herein above and later below may be suitably combined with each other as would be apparent to anyone of ordinary skill in the art.

Additional features and advantages are disclosed in the following description, claims, and drawings, and in part will be readily apparent therefrom to those skilled in the art or recognized by practicing the disclosure as described herein.

BRIEF DESCRIPTION OF THE DRAWINGS

Further objects and advantages of, and features of the disclosure will be apparent from the following description of one or more embodiments, with reference to the appended drawings, where:

Fig. 1    shows an example of an electrostatic shielding element according to the first aspect of the disclosure.

Fig. 2    shows an example of an electrostatic shielding element according to the first aspect of the disclosure.

Fig. 3    shows an example of an electrostatic shielding element according to the first aspect of the disclosure.

Fig. 4    shows an example of an electrostatic shielding element according to the first aspect of the disclosure.

Fig. 5    shows a diagram of exemplary experimental results.

Fig. 6    shows an example of an electrostatic shielding arrangement according to the second aspect of the disclosure.

Fig. 7    shows an example of an electrostatic shielding arrangement according to the second aspect of the disclosure.

Fig. 8    shows an example of a transformer arrangement according to the third aspect of the disclosure.

DETAILED DESCRIPTION OF EXAMPLE EMBODIMENTS OF THE INVENTION

The present disclosure is developed in more detail below referring to the appended drawings which show examples of embodiments. The disclosure should not be viewed as limited to the described examples of embodiments. Like numbers refer to like elements throughout the description.

The terminology used herein is for the purpose of describing particular aspects of the disclosure only and is not intended to limit the invention. As used herein, the singular forms "a", "an" and "the" are intended to include the plural forms as well, unless the context clearly indicates otherwise. Unless otherwise defined, all terms (including technical and scientific terms) used herein have the same meaning as commonly understood by one of ordinary skill in the art to which this disclosure belongs.

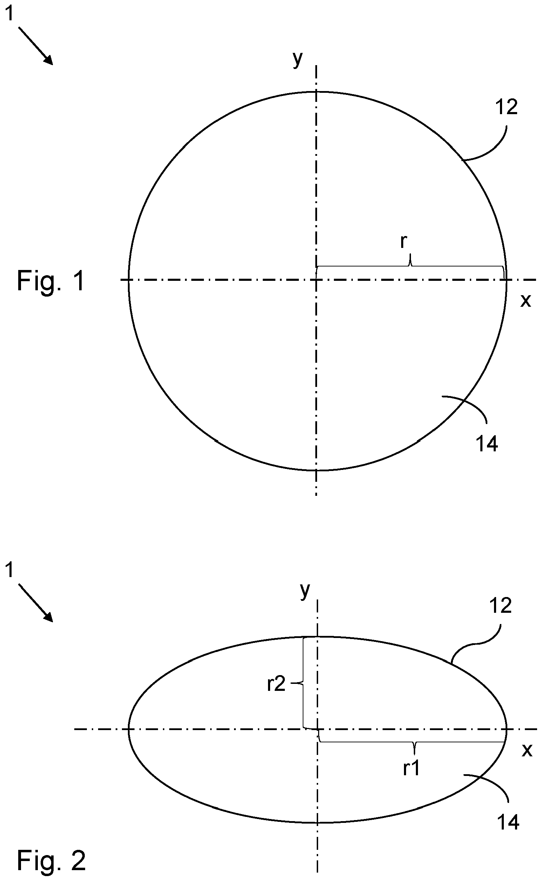

**Fig. 1** shows an electrostatic shielding element 1 for protection against electric fields. The electrostatic shielding element 1 is shown arranged on a first axis z, as viewed along the first axis z. The electrostatic shielding element 1 comprises an electrostatically shielded volume 14 at least partially closed by an electrically conductive coating 12, wherein a thickness d and an electrical conductivity $\sigma$ of the coating 12 are selected to enable a magnetic field of a predetermined frequency f to penetrate the coating, into the volume 14. The volume 14 may extend laterally from the first axis z. The volume 14 may be disc-shaped, having a significantly larger lateral extension from the first axis z than along the first axis z. As illustrated in **Fig. 1**, the volume 14 may be circular around the first axis z, having a radius r. For a single shielding element 1, the electrostatically shielded volume 14 may be fully closed by the electrically conductive coating 12. The shielded volume 14 may be partially closed, i.e. partly open, if an open area of the shielded volume 14 is covered by an adjacent galvanically connected conductive body, such as another shielding element 1.

As shown in **Fig. 2,** the volume 14 may alternatively be elliptical around the first axis z. The elliptical volume 14 may extend a first distance r1 along a second (major) axis x, orthogonal to the first axis z. The elliptical volume 14 may also extend a second distance r2 along a third (minor) axis y, orthogonal to both the first axis z and to the second axis x. A circular or elliptical volume 14 around the first axis z is preferred since in order to reduce the risk of field intensification at corners and edges.

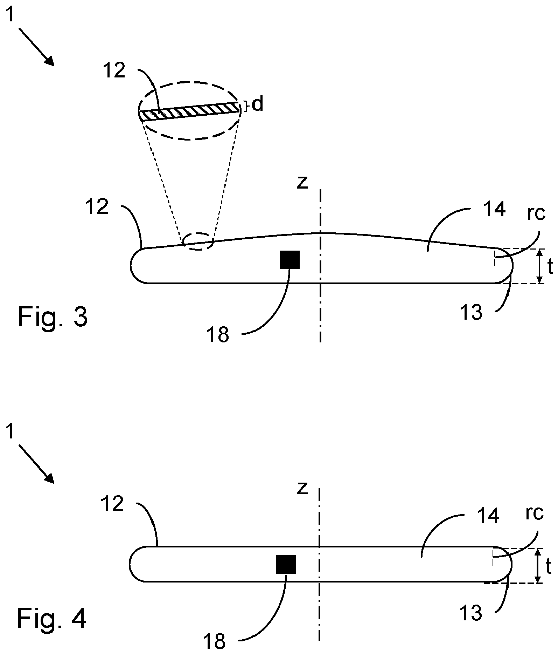

**Fig. 3** and **Fig. 4** show side views of the electrostatic shielding element 1 according to the first aspect of the disclosure. The electrostatic shielding element 1 is viewed either along the second axis x or the third axis y, i.e. perpendicularly to the first axis z. In Fig. 3, the volume 14 has a slightly conic or parabolic shape around the first axis z and in Fig. 4 the volume 14 is substantially flat around the first axis z. Both shapes are equally conceivable.

Further, a radial outer periphery, or edge, 13 of the volume 14 may have a rounded shape in a plane parallel with the first axis z. A radius of curvature rc of the radial outer edge may preferably be half a volume thickness t at the radial outer edge 13, as seen along the first axis z.

**Fig. 3** shows a detailed view of the coating 12. The electrostatically shielded volume 14 is configured to be protected from an electric field at 50Hz/60Hz working frequencies. To this end, a coating material needs to be sufficiently electrically conductive. The coating material also needs to be continuous to fully close the volume 14.

By appropriately selecting the conductivity σ and thickness d of the coating 12, the magnetic field is enabled to penetrate into the volume 14 to enable power transfer and signalling to electrical devices comprised in the volume 14.

The coating 12 is preferably a conductive metallic coating 12. Eddy currents are induced in the coating 12 when the coating 12 is exposed to an incident magnetic field. Eddy current effects increase with increasing frequency of the magnetic field and prevent the magnetic field from penetrating the shielded volume. Eddy current effects decrease with decreasing conductivity σ of the coating material.

A thicker coating 12 requires a lower conductivity σ than a thinner coating 12 to allow penetration of the magnetic field into the volume 14. However, a thicker coating 12 has a better mechanical strength than a thinner coating 12.

For the predetermined frequency f, the electrical conductivity σ and the thickness d of the coating 12 may be selected so that

$$\sigma d^2 < \frac{c}{f}$$

where c is a constant which is less than or equal to 40 000 Sm/s, which allows around 10% of the signal power of the magnetic field to penetrate the coating 12. Preferably, c is less than or equal to 5 000 Sm/s, resulting in around 50% of the signal power penetrating the coating 12. Most preferably, c is less than or equal to 1 000 Sm/s, allowing 90% of the signal power to penetrate the coating 12.

The frequency f of the magnetic field for power transfer and signalling applications is conventionally between 20kHz and 20MHz. Designing electric devices and electronic components for a predetermined frequency f in the range thereby limits the range of selectable coating conductivities/materials and coating thicknesses.

The thickness of the electrically conductive layer may be between less than or equal to 1 mm.

The electrical conductivity σ of the electrically conductive layer (or coating) 12 is in the range of 1 S/m - $10^8$ S/m, preferably in the range of $10^3$ S/m - $10^8$ S/m, and most preferably $10^5$ S/m - $10^8$ S/m. A conductivity of less than $10^8$ S/m covers conductive materials, such as metals. It is also conceivable to use coatings of semiconductor materials, at at least $10^5$ S/m and materials such as carbon/graphite at around 1 S/m.

As exemplified in **Fig. 3** and in **Fig. 4,** the electrostatic shielding element 1 comprises at least one electric device 18 enclosed in the volume 14. The electric device 18 may be configured to receive electric power by inductive coupling, and/or to be communicatively coupled to a magnetic field of the predetermined frequency f.

The electric device 18 may be enclosed and electrostatically shielded inside the coated volume 14. Electric power may be inductively wirelessly received and transferred to another electric device 18 or component. In addition, the electric device 18 may be communicatively coupled to the magnetic field to receive and/or to send signals via the magnetic field to/from receivers/transmitters outside the electrostatically shielded volume (not shown). The electrostatic shielding element 1 may thereby be located in a high voltage electric field without risking damage to the electric device or to surrounding instruments and/or equipment.

The electric device 18 may comprise at least one LC circuit. The LC circuit may comprise a single LC circuit or multiple LC circuits, such as an array of LC circuits. Electric devices 18 that receive power from magnetic fields and which may perform wireless power transfer and signalling are conventional devices are not described in detail in the present disclosure.

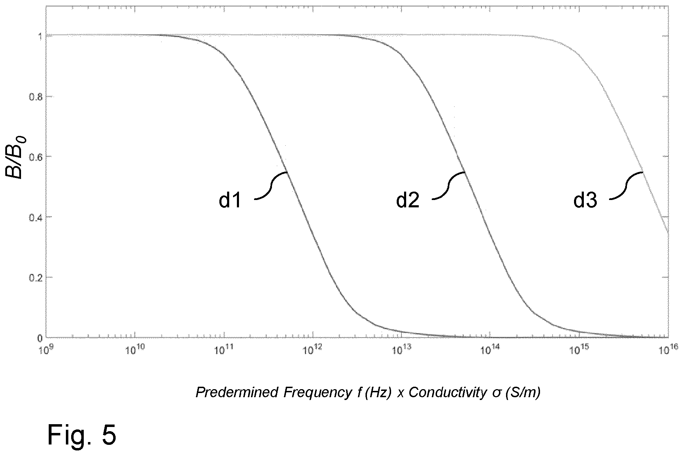

**Fig. 5** shows simulated results of variation of magnetic field penetration into the volume 14. The vertical axis represents how well the magnetic field penetrates the coating 12 into the volume 14. The value 1 is very good penetration and the value 0 is no penetration. The horizontal axis is the product fσ. Three examples are shown for different coating thicknesses d1, d2 and d3, where d1=100 μm, d2=10 μm and d3=1 μm.

As the simulated example illustrates, for the case of d2, the magnetic field almost fully passes through the coating 12 when frequency f * conductivity σ is less than $10^{13}$ and is almost fully blocked when the product exceeds $10^{15}$. In the range $10^{13}$ < frequency f x conductivity σ < $10^{15}$, varying degrees of magnetic field penetration exist. Therefore, for a predetermined frequency f of 1 MHz for a magnetic field to fully pass through a 10 μm thick coating 12, it must be ensured that

$$f \times \sigma < 10^{13} \Rightarrow \sigma < \frac{10^{13}}{10^6} \Rightarrow \sigma < 10^7 S/m$$

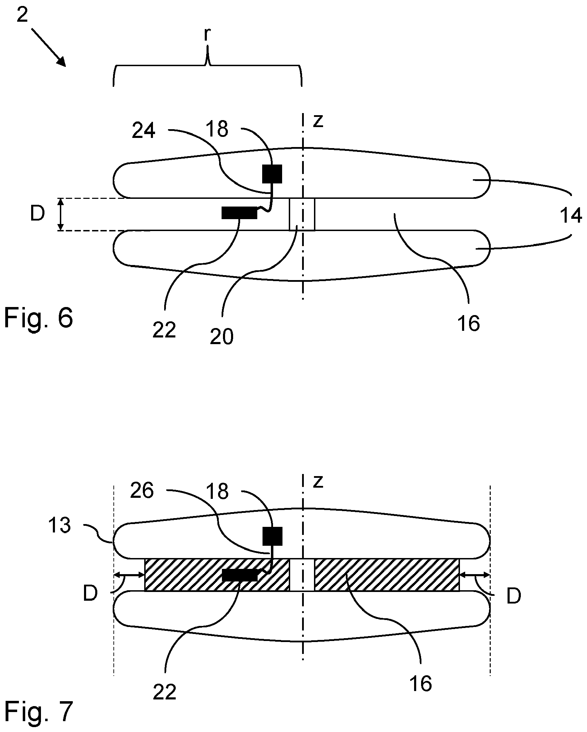

**Fig. 6** shows an electrostatic shielding arrangement 2 according to the second aspect of the disclosure. The electrostatic shielding arrangement 2 comprises at least two electrostatic shielding elements 1 according to any one of the examples described above. The electrostatic shielding elements 1 are galvanically connected to each other and the at least two electrostatic shielding elements 1 are arranged along the first axis z, spaced from each other, forming an electrostatically shielded space 16 therebetween.

The galvanic connection between the at least two electrostatic shielding elements 1 ensure an equipotential surface across a surface of the entire electrostatic shielding arrangement 2, which further ensures a negligible electric potential in the shielded space 16. They are both arranged on the first axis z, e.g. in parallel with each other along the first axis z. The electrostatically shielded space 16 between the electrostatic shielding elements 1 therefore also extends laterally from the first axis z. The shielded space 16 may comprise any components that require shielding from the electric field, but which require contact with an environment outside the electrostatic shielding elements 1, i.e. an environment in which the electrostatic shielding arrangement 2 is placed.

The at least two electrostatic shielding elements may be mechanically and galvanically connected to each other via at least one electrically conductive fixing element.

The galvanic connection may be achieved by an electrically conductive fixing element 20, such as a screw or bolt, which engages the at least two electrostatic shielding elements 1. The fixing element 20 may also be electrically conductive by being provided by a conductive coating, such as the same coating 12 as the at least two electrostatic shielding elements 1.

The electrostatic shielding arrangement 2 may comprise at least one electronic component 22 arranged in the electrostatically shielded space 16, and the electric device 18 may be electrically connected to the electronic component 22.

The electronic component 22 may be located in the electrostatically shielded space 16 without risking interference from an electric field external to the electrostatic shielding arrangement 2. The electric component 22 may be electrically connected to the electric device 18, which electric device is located inside the electrostatic shielding element 1, via an electric conductor 26 passing through the coating 12 of the electrostatic shielding element 1 via a wall of the electrostatic shielding element which borders the electrostatically shielded space 16. Alternatively, the electric component 22 may be wirelessly connected to the electric device, such as if the electric component 22 is inductively coupled to the electric device. The electric component 22 may in this example comprise at least one LC circuit.

The at least two electrostatic shielding elements 1 may be spaced at least a separation distance D from each other. The electronic component 22 may be located in the shielded space 16, at least at the separation distance D from the radial periphery 13 of the at least two electrostatic shielding elements 1. Usually, the separation distance is defined as a distance along the first axis z between radial peripheries 13 of the electrostatic shielding elements 1. The separation distance D is preferably significantly smaller than the radius r, r1, r2 of the electrostatic shielding elements 1. As an example the separation distance D is less than or equal to a fifth of the radius r, r1, r2. In case of an elliptic electrostatic shielding element the separation distance is determined in relation to the extension along the minor axis of the elliptic body, i.e. along the third axis y.

The distance between the at least two electrostatic shielding elements 1 may vary over the shielded space. As a rule of thumb, the electric field is negligible at a distance equalling the separation distance D from the radial periphery 13 of the at least two electrostatic shielding elements 1. Therefore, the electronic component 22 is protected if it is located in the electrostatically shielded space 16 at least the separation distance from the radial periphery of the electrostatic shielding elements. The shielded space 16 is delimited and exemplified by the dashed area in **Fig. 7**.

The electronic component 22 may be a sensor 22 electrically powered by, and/or communicatively coupled to the electric device 18.

A sensor 22 located in the electrostatically shielded space 16 is exposed to the environment in which the electrostatic shielding arrangement 2 is positioned. Such a sensor may therefore measure properties such as temperature, pressure, humidity, etc., without being exposed to the electric field and without risking field intensification and/or electric breakdown of the medium in which it is placed, which could lead to damaging arcing. The sensor 22 may be powered by the electric device 18 which is inductively coupled to the magnetic field.

The shielded space 16 may comprise a field grading material or a dielectric material. The field grading material may be a non-linear resistive field grading material. The primary characteristic of a non-linear resistive field grading material is that the electrical conductivity increases above a threshold electric field amplitude and therefore can be used to reduce a maximum field stress at locations inside the insulation system. A field grading material composite may generally be composed of a base polymer e.g. SiR, ethylene propylene-diene monomer rubber, epoxy resins or thermoplastics and may be filled with a single or plurality of fillers, often conducting or semiconducting to achieve nonlinear behaviour. The non-linear conductivity behaviour of the composite originates from the semiconducting fillers. A filler material may be silicon carbide, but alternatives exist.

Any suitable dielectric material may be used, such as pressboard, paper, cellulose or impregnated cellulose, dielectric polymer, etc. A fluid dielectric material may alternatively be used or to complement a solid dielectric material. Fluid dielectric materials may be exemplified by air, oil, etc. The field grading material or dielectric material may partially or fully fill out the shielded space 16.

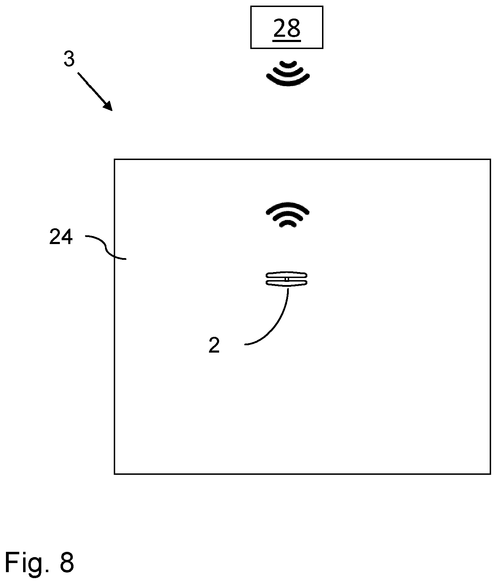

Fig. 8 conceptually shows a transformer arrangement 3 according to the third aspect of the present disclosure. The transformer arrangement 3 comprises a transformer 24 and the electrostatic shielding arrangement 2 according to any one of the examples described above. Accordingly, the electrostatic shielding arrangement 2 may be provided in a transformer arrangement 3. The electrostatic shielding arrangement 2 may protect and drive sensors 22 to monitor the transformer 24 during operation. Due to the shielding properties of the electrostatic shielding element 1, the transformer 24 does not need to be disconnected for any sensors to perform measurements.

Any the transformer arrangement 3 may comprise a monitoring unit 28 and may be configured such that the electronic component 22 is wirelessly communicatively coupled via the electric device 18 and via the magnetic field to the control unit 28. The control unit 28 may be configured to transfer power via the magnetic field to the electric device 18 and to receive signals, such as sensor data, via the magnetic field from the electronic component 22 via the electric device 18.

**Claims**

1. An electrostatic shielding element (1) arranged on a first axis (z) and comprising an electrostatically shielded volume (14) at least partially closed by an electrically conductive coating (12), wherein a thickness (d) and an electrical conductivity (σ) of the coating (12) are selected to enable a magnetic field of a predetermined frequency (f) to penetrate the coating, into the volume (14).

2. The electrostatic shielding element (1) of claim 1, wherein the volume (14) extends laterally from the first axis (z).

3. The electrostatic shielding element (1) of claim 2, wherein the volume (14) is circular or elliptical around the first axis (z) and wherein a circular volume (14) has a radius (r) extending orthogonally from the first axis (z), and wherein an elliptical volume (14) extends a first distance (r1) along a second axis (x) orthogonal to the first axis (z), and extends a second distance (r2) along a third axis (y) orthogonal to both the first axis (z) and to the second axis (x).

4. The electrostatic shielding element (1) of any of claims 1-3, wherein, for the predetermined frequency (f), the electrical conductivity (σ) and the thickness (d) of the coating (12) are selected so that

$$\sigma d^2 < \frac{c}{f}$$

wherein c ≤ 40 000 Sm/s.

5. The electrostatic shielding element (1) of any of claims 1-4, wherein the thickness (d) of the coating (12) is less than, or equal to 1 mm.

6. The electrostatic shielding element (1) of any of claims 1-5, wherein the electrical conductivity (σ) of the coating (12) is in the range of 1 S/m - $10^8$ S/m.

7. The electrostatic shielding element (1) of any of claims 1-6, comprising at least one electric device (18) is enclosed in the volume (14), wherein the electric device (18) is configured receive electric power by inductive coupling, and/or to be communicatively coupled, to a magnetic field of the predetermined frequency (f).

8. The electrostatic shielding element (1) of claim 7, wherein the electric device (18) comprises at least one LC circuit.

9. An electrostatic shielding arrangement (2) comprising at least two electrostatic shielding elements (1) according to any of claims 1-8, galvanically connected to each other, the at least two electrostatic shielding elements (1) being arranged along the first axis (z) spaced from each other, forming an electrostatically shielded space (16) therebetween.

10. The electrostatic shielding arrangement (2) of claim 9, wherein the at least two electrostatic shielding elements (1) are mechanically and galvanically connected to each other via at least one electrically conductive fixing element (20).

11. The electrostatic shielding arrangement (2) of any of claims 8-10, when dependent on claim 7 or 8, comprising at least one electronic component (22) arranged in the electrostatically shielded space (16), and wherein the electric device (18) is electrically connected to the electronic component (22).

12. The electrostatic shielding arrangement (2) of claims 11, wherein the at least two electrostatic shielding elements (1) are spaced at least a separation distance (D) from each other, and wherein the electronic component (22) is located in the shielded space (16), at least at the separation distance (D) from a radial periphery (13) of the at least two electrostatic shielding elements (1).

13. The electrostatic shielding arrangement (2) of any of claims 11-12, wherein the electronic component is a sensor (22) electrically powered by, and/or communicatively coupled to the electric device (18).

14. The electrostatic shielding arrangement (2) of any of claims 11-13, wherein the shielded space comprises a field grading material or a dielectric material.

15. A transformer arrangement (3) comprising a transformer (24) and the electrostatic shielding arrangement of any of claims 8-14.

Fig. 1

Fig. 2

1

12

d

12

z

14

rc

18

t

13

Fig. 3

1

12

z

14

rc

18

t

13

Fig. 4

*Predermined Frequency f (Hz) x Conductivity σ (S/m)*

# Fig. 5

2

r

24    18    z

D

14

Fig. 6

22    20    16

26    18    z

13

D    D

Fig. 7

22    16

**28**

**3**

**24**

**2**

Fig. 8

Europäisches
Patentamt

European
Patent Office

Office européen
des brevets

## EUROPEAN SEARCH REPORT

Application Number

EP 22 21 3124

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 360 941 A (ROES JOHN B [US]) 1 November 1994 (1994-11-01) | 1-3, 5-11,15 | INV. H05K9/00 |
| Y | * abstract * | 13 | |
| A | * column 3, line 47 - column 4, line 38 * * column 5, line 4 - column 6, line 7 * * column 6, lines 15-60 * * figures 1-5 * | 4 | |
| | ----- | | |
| X | EP 3 582 965 A1 (ILLINOIS TOOL WORKS [US]) 25 December 2019 (2019-12-25) * paragraphs [0014] - [0016], [0021] - [0026] * * figures 3,6 * | 1-3, 5-12,14, 15 | |
| | ----- | | |
| Y | US 4 451 812 A (VESCOVI VALENTINO F [AU] ET AL) 29 May 1984 (1984-05-29) * abstract * * figures 1-4 * * column 1, lines 8-12 * * column 1, line 66 - column 2, line 37 * * column 2, lines 55-59 * * column 3, lines 3-15 * * column 3, line 32 - column 4, line 25 * * column 4, lines 51-54 * | 13 | TECHNICAL FIELDS SEARCHED (IPC) H05K |
| | ----- | | |

The present search report has been drawn up for all claims

| Place of search | Date of completion of the search | Examiner |
|---|---|---|
| The Hague | 10 May 2023 | Beaudet, J |

EPO FORM 1503 03.82 (P04C01)

## ANNEX TO THE EUROPEAN SEARCH REPORT
## ON EUROPEAN PATENT APPLICATION NO.

EP 22 21 3124

This annex lists the patent family members relating to the patent documents cited in the above-mentioned European search report.
The members are as contained in the European Patent Office EDP file on
The European Patent Office is in no way liable for these particulars which are merely given for the purpose of information.

10-05-2023

| Patent document cited in search report | | Publication date | Patent family member(s) | | Publication date |
|---|---|---|---|---|---|
| US 5360941 | A | 01-11-1994 | AU | 2893692 A | 07-06-1993 |
| | | | CA | 2121366 A1 | 13-05-1993 |
| | | | EP | 0610311 A1 | 17-08-1994 |
| | | | US | 5360941 A | 01-11-1994 |
| | | | WO | 9309650 A1 | 13-05-1993 |
| EP 3582965 | A1 | 25-12-2019 | CN | 110267806 A | 20-09-2019 |
| | | | EP | 3582965 A1 | 25-12-2019 |
| | | | ES | 2910122 T3 | 11-05-2022 |
| | | | RU | 2744250 C1 | 04-03-2021 |
| | | | US | 2018232616 A1 | 16-08-2018 |
| | | | WO | 2018151999 A1 | 23-08-2018 |
| US 4451812 | A | 29-05-1984 | AU | 535599 B1 | 29-03-1984 |
| | | | AU | 5880780 A | 08-01-1981 |
| | | | CA | 1138084 A | 21-12-1982 |
| | | | DE | 3021164 A1 | 08-01-1981 |
| | | | FI | 801932 A | 20-12-1980 |
| | | | FR | 2459537 A1 | 09-01-1981 |
| | | | GB | 2057136 A | 25-03-1981 |
| | | | JP | S5612799 A | 07-02-1981 |
| | | | US | 4451812 A | 29-05-1984 |

EPO FORM P0459

For more details about this annex : see Official Journal of the European Patent Office, No. 12/82